# EUROPEAN PATENT APPLICATION

(11) **EP 1 179 836 A2**
(43) Date of publication of application: **13.02.2002**
(21) Application number: 01306774.9
(22) Date of filing: 08.08.2001
(51) Int. Cl.: H01L 21/285

(54) **A contact for indium semiconductor devices incorporating gold solders**

(30) Priority: 11.08.2000 US 636670
(71) Applicant: Agere Systems Optoelectronics Guardian Corporation, Orlando, Florida 32819-8698 (US)
(72) Inventor: Baron, Robert Anthony, Mohrsville, Pennsylvania 19541 (US); Chakrabarti, Utpal Kumar, Allentown, Pennsylvania 18104 (US); Derkits, Gustav Edward, New Providence, New Jersey 07974 (US); Muthiah, Ranjanic, Upper Macungie Township, PA 18104 (US)
(74) Representative: Williams, Ceili

(57) **Abstract**

The invention provides a semiconductor device, comprising a substrate comprising indium, an ohmic contact layer on the substrate, an indium diffusion barrier layer over the ohmic contact layer, and a layer selected from the group consisting of gold solder, gold solder precursor and mixtures thereof over the indium diffusion barrier layer and a method for making such a device.

## Description

The invention relates to indium-containing semiconductor devices.

Manufacturing of semiconductor devices often involves a process called "step soldering." In step-soldering, assemblies are built-up by using solders with sequentially lower melting points, so that a solder joint made early in the process does not melt and reflow during subsequent operations. The highest melting temperature solders used in electronic manufacture are gold based, such as gold-tin and gold-germanium solders. Gold solders are used at the semiconductor substrate fabrication step so to prevent solder reflow when a device containing the gold solder is then soldered to, for example, a printed circuit board with lead -tin solder, which has a lower melting point than gold-based solder. There is a problem however, when the semiconductor substrate contains indium. Indium rapidly diffuses and forms a high melting point intermetallic compound when it combines with gold. The melting point is higher than that of gold-based solder. In the presence of gold, and the heat of soldering, indium can diffuse into the gold and raise the melting point of the gold solder to the point where the temperature required to melt the solder is deleteriously high, such as high enough to overdiffuse the device junctions and to degrade device performance.

This invention provides a semiconductor device, comprising a substrate comprising indium, an ohmic contact layer on the substrate, an indium diffusion barrier layer over the ohmic contact layer, and a layer selected from the group consisting of gold solder, gold solder precursor and mixtures thereof over the indium diffusion layer. In another aspect this invention also provides a method for making such a device.

The invention is best understood from the following detailed description when read in connection with the accompanying drawing. It is emphasized that, according to common practice in the semiconductor industry, the various features of the drawing are not to scale. On the contrary, the dimensions of the various features are arbitrarily expanded or reduced for clarity. Included in the drawing are the following figures:
Fig. 1 is a cross-sectional view of a prior art gold solder contact on an InP substrate;
Fig. 2 is a cross-sectional view of a gold-based contact on an InP substrate with an indium diffusion barrier between the substrate and the gold-solder contact, for one embodiment of the invention.
Fig. 3 is a cross-sectional view of a gold-based contact on an InP substrate with an indium diffusion barrier between the substrate and the gold-solder contact, for another embodiment of the invention.

The present invention overcomes the limitations of the prior art by, for example, interposing a barrier layer between a substrate containing indium and gold solder, the barrier layer inhibiting the diffusion of indium into the gold solder.

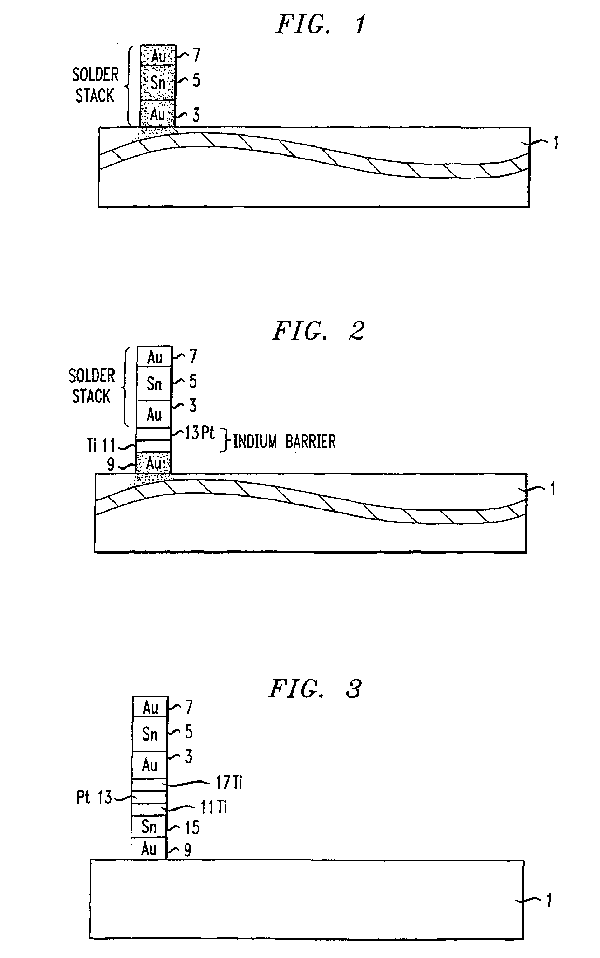

Referring now to the drawing, wherein like reference numerals refer to like elements throughout, Fig. 1 is a cross-sectional view of a prior art gold solder contact 3, 5, 7 on an indium containing substrate 1, in this example the substrate is indium phosphide. What is actually illustrated in this example is not gold solder, although it is also often used, but stack up of a gold layer 3, a tin layer 5 and a second gold layer 7, that forms a gold solder precursor, which, upon heating to soldering temperature, alloys to form gold-tin solder. Unfortunately, indium from the substrate 1 can diffuse into the gold layer 3 and the resulting gold solder to undesirably increase the melting point of the solder.

Figure 2 shows, for one embodiment of the invention that by first depositing an ohmic contact layer 9, in this embodiment gold, and then covering it with an indium diffusion barrier, in this embodiment, a layer 11 of titanium and a layer 13 of platinum, diffusion of indium is inhibited, resulting in minimizing an undesirable increase in the melting point of the gold layer 3 and the resulting gold solder (not shown). In this way, any gold in the ohmic contact, which is not required to melt, is exposed to indium, while the gold solder or gold solder precursor melts with reduced influence from the indium.

It is desired that the materials comprising the diffusion barrier have melting points higher than that of gold solder and good adhesion to the ohmic contact layer 9 and the gold layer 3. Materials that may be used in contact with the ohmic contact layer 9 are chromium, nickel, tungsten and molybdenum. Titanium is preferred. Materials that may be used in contact with the gold layer 3 or prealloyed gold solder (not shown in the embodiment of Fig. 2) include nickel, palladium, molybdenum and tungsten. Platinum is preferred. Note that some metals appear in both list, and may be used as single-layer indium diffusion barriers.

Figure 3 shows a preferred embodiment of the invention. A layer of material that forms a gold solder upon melting, such as tin or germanium, is deposited upon the ohmic contact layer 9. Also, when material capable of forming tin alloys are used in contact with the gold solder (not shown) or gold solder precursor stack 3, 5, 7, a metal layer 17 with reduced tendency to alloy with tin or germanium, titanium is preferred, is deposited adjacent to the gold precursor stack 3, 5, 7.

The substrate 1 may be any III-V semiconductor comprising indium. These include indium arsenide and indium antimonide. Indium phosphide is preferred. The indium containing III-V semiconductor may further comprise aluminum and gallium.

The preferred material of the ohmic contact layer 9 is a material that does not form a diode junction with the indium containing III-V semiconductor of interest. Gold is particularly preferred.

The gold solder may be a prealloyed gold solder or it may be provided as a stack up of layers of metals comprising the metals that make up the desired gold solder alloy. The gold solder may also be provided as a paste of gold solder powder in flux. Gold solders such as gold-germanium may be used. Gold-tin solder or a stack up of gold tin gold layers is particularly preferred.

Deposition of the ohmic contact layer, the indium barrier layer(s), and the gold solder or gold solder precursor layers may be accomplished by any conventional means such as evaporation, sputtering, chemical vapor deposition and the like. Note that gold solder paste may be deposited by dot dispensing equipment.

## Claims

1. A semiconductor device, comprising:
a semiconductor substrate containing indium; and
at least one solder layer selected from the group consisting of gold solder, gold solder precursor and mixtures thereof
**characterised in that** intermediate the substrate and solder layer, the device comprises:
an ohmic contact layer on the substrate; and
an indium diffusion barrier layer over the ohmic contact layer and below the solder layer.

2. The device of claim 1, wherein the indium diffusion barrier layer comprises a first layer selected from the group consisting of titanium, chromium, nickel, tungsten and molybdenum over the ohmic contact layer and a second layer selected from the group consisting of platinum, nickel, palladium, molybdenum and tungsten over the first layer.

3. The device of claim 1 or 2, wherein the ohmic contact layer is gold.

4. The device of claim 1, 2 or 3, wherein the gold solder is at least one of gold tin solder and gold germanium solder.

5. The device of any preceding claim, wherein a layer of material capable of forming a gold solder when alloyed with gold is deposited on the ohmic contact and is selected from the group consisting of germanium and tin.

6. A method of making a semiconductor device, the method comprising:
depositing an ohmic contact layer on a semiconductor substrate containing indium;
depositing an indium diffusion barrier layer over the ohmic contact layer; and
depositing at least one layer selected from the group consisting of gold solder, gold solder precursor and mixtures thereof over the indium diffusion barrier layer.

7. The method of claim 6, wherein the indium diffusion barrier layer deposition step comprises depositing a first layer selected from the group consisting of titanium, chromium, nickel, tungsten and molybdenum over the ohmic contact layer and depositing a second layer selected from the group consisting of platinum, nickel, palladium, molybdenum and tungsten over the first layer.

8. The method of claim 6 or 7, wherein the ohmic contact layer is gold.

9. The method of claim 6, 7 or 8, wherein the gold solder is at least one of gold tin solder and gold germanium solder.

10. The method of any one of claims 6 to 9, further comprising the step of depositing on the ohmic contact a layer of material capable of forming a gold solder when alloyed with gold and which is selected from the group consisting of germanium and tin.
